# EUROPEAN PATENT APPLICATION

(11) **EP 4 503 098 A1**
(43) Date of publication of application: **05.02.2025**
(21) Application number: 23779094.4
(22) Date of filing: 24.02.2023
(51) Int. Cl.: H01L 21/3065, H05H 1/46

(54) **HEAT TRANSFER MEMBER, METHOD FOR MANUFACTURING HEAT TRANSFER MEMBER, AND PLASMA TREATMENT DEVICE**

(30) Priority: 30.03.2022 JP 2022057297
(71) Applicant: Mitsubishi Materials Corporation, Tokyo 100-8117 (JP)
(72) Inventor: SHOJI, Miho, Amagasaki-shi, Hyogo 660-0856 (JP); ZUSHI, Toshihiro, Amagasaki-shi, Hyogo 660-0856 (JP); HIRANO, Kosei, Amagasaki-shi, Hyogo 660-0856 (JP); YAMAMOTO, Tetsuya, Amagasaki-shi, Hyogo 660-0856 (JP)
(74) Representative: Hoffmann Eitle
(86) International application number: PCT/JP2023/006657
(87) International publication number: WO 2023/189064

(57) **Abstract**

This heat transfer member is a heat transfer member constituted of a fired body of a molded object including a fluorine-based resin or a fluorine-based elastomer, in which a hardness measured using a type AM durometer conforming to JIS K 6253-3:2012 is lower by 7 or greater than a hardness of the molded object. This heat transfer member has a high plasma resistance and can maintain a high state of adhesion with respect to various members over a long period of time.

## Description

### TECHNICAL FIELD

The present invention relates to a heat transfer member, a method for manufacturing a heat transfer member, and a plasma treatment device.

Priority is claimed on Japanese Patent Application No. 2022-057297, filed March 30, 2022, the content of which is incorporated herein by reference.

### BACKGROUND ART

The inside of a chamber is maintained in a vacuum state during plasma treatment of a plasma treatment device. For this reason, there is a problem that heat transfer between components inside the chamber is low and it takes time to make the temperature of each component stable. Hence, disposing a heat transfer member between components inside the chamber is being studied.

For example, Patent Documents 1 and 2 have proposed disposing a heat transfer member between an electrode for a plasma treatment device and a cooling plate or between a focus ring inside a chamber of a plasma treatment device and a support stand therefor. Patent Document 1 has proposed using a flexible heat transfer sheet as a heat transfer member and has described heat-resistant silicone rubber as the flexible heat transfer sheet. In addition, Patent Document 2 has proposed using a fluorine-based resin or a fluorine-based elastomer as a heat transfer member.

### CITATION LIST

### Patent Document

[Patent Document 1]
   Japanese Patent No. 5619486
[Patent Document 2]
   Japanese Unexamined Patent Application, First Publication No. 2021-141314

### SUMMARY OF INVENTION

### Technical Problem

In order to improve the heat conductivity between components inside a chamber of a plasma treatment device, it is effective to increase flexibility of a heat transfer member to enhance adhesion between the components and the heat transfer member. However, silicone rubber which has been used as a flexible heat transfer member in the related art has a problem of a low plasma resistance. When a heat transfer member having a low plasma resistance is used for components inside a chamber of a plasma treatment device, there is concern that it may be degenerated over time, resulting in deterioration in adhesion to the components. Meanwhile, although a fluorine-based resin and a fluorine-based elastomer have a high plasma resistance, there is demand for further improvement in adhesion to various members in order to enhance heat transfer characteristics.

This invention has been made in consideration of the circumstances described above, and an object thereof is to provide a heat transfer member and a method for manufacturing the same having a high plasma resistance and capable of maintaining a high state of adhesion with respect to various members over a long period of time, and a plasma treatment device in which the temperature of each component inside a chamber is likely to be made stable even if the inside of the chamber is in a vacuum state.

### Solution to Problem

In order to resolve the foregoing problems, the present invention includes aspects as follows.

[Aspect 1] A heat transfer member according to Aspect 1 of the present invention is a heat transfer member constituted of a fired body of a molded object including a fluorine-based resin or a fluorine-based elastomer. A hardness measured using a type AM durometer conforming to JIS K 6253-3:2012 is constituted to be lower by 7 or greater than a hardness of the molded object.

According to the heat transfer member of Aspect 1, since the heat transfer member includes a fluorine-based resin and/or a fluorine-based elastomer, it has a high plasma resistance. In addition, the heat transfer member of the present invention is a fired body, of which a hardness AM has a value lower by 7 or greater than the hardness AM of the molded object before firing, and therefore it has a low hardness and high flexibility. For this reason, according to the heat transfer member of the present invention, adhesion of the heat transfer member with respect to various components is improved.

[Aspect 2] According to the heat transfer member of Aspect 2, in Aspect 1, the molded object includes a filler. In this case, it is desirable that the filler have a higher heat conductivity than those of a fluorine-based resin and a fluorine-based elastomer.

According to the heat transfer member of Aspect 2, since the filler has a higher heat conductivity than those of a fluorine-based resin and a fluorine-based elastomer, the heat conductivity of the heat transfer member is further improved.

[Aspect 3] According to the heat transfer member of Aspect 3 of the present invention, in Aspect 2, the filler is at least one kind of inorganic materials selected from the group consisting of alumina, aluminum nitride, boron nitride, and silicon. In this case, since the filler is the foregoing inorganic material, the heat conductivity of the heat transfer member is further improved.

[Aspect 4] A heat transfer member according to Aspect 4 of the present invention is a heat transfer member constituted of a molded product including a fluorine-based resin and/or a fluorine-based elastomer. When heating is performed at 250°C for 25 hours and a hardness is measured using a type AM durometer conforming to JIS K 6253-3:2012 before and after the heating, an amount of change in hardness from before the heating until after the heating (hardness after heating - hardness before heating) is within a range of ±5. The atmosphere during the heat treatment is set to an atmosphere of air at a normal pressure or an inert gas such as nitrogen, and the temperature of the heat transfer member during hardness measurement is set to a normal temperature.

Since the heat transfer member according to Aspect 4 includes a fluorine-based resin and/or a fluorine-based elastomer, it has a high plasma resistance. In addition, in the heat transfer member of Aspect 4, since the amount of change in the foregoing hardness after heating at 250°C for 25 hours is within a range of ±5, it has high thermal stability, and flexibility of the heat transfer member is enhanced. For this reason, according to the heat transfer member of Aspect 4, adhesion of the heat transfer member with respect to various components is improved. In addition, since the heat transfer member of Aspect 4 has high thermal stability, it can maintain a high state of adhesion with respect to various members over a long period of time even under a high-temperature environment such as inside a chamber of a plasma treatment device. The heat transfer member of Aspect 4 may also satisfy the requirements of the heat transfer member of Aspect 1.

[Aspect 5] According to the heat transfer member of Aspect 5, in Aspect 4, the molded product may be constituted to include a filler. In this case, since the filler has a higher heat conductivity than those of a fluorine-based resin and a fluorine-based elastomer, the heat conductivity of the heat transfer member is further improved.

[Aspect 6] According to the heat transfer member of Aspect 6, in Aspect 5, the filler may be constituted to be at least one kind of inorganic materials selected from the group consisting of alumina, aluminum nitride, boron nitride, and silicon. In this case, since the filler is the foregoing inorganic material, the heat conductivity of the heat transfer member is further improved.

The amount of the fluorine-based resin and/or the fluorine-based elastomer contained in the heat transfer members of Aspects 1 to 6 is not limited. However, it may be 10% by volume to 100% by volume, is preferably 20% by volume to 80% by volume, or is more preferably 40% by volume to 60% by volume. If the amount of the fluorine-based resin or the fluorine-based elastomer contained therein is 20% by volume or larger, the plasma resistance is likely to be sufficiently increased, and it is easier to maintain a high state of adhesion with respect to various members over a long period of time.

The shapes of the heat transfer members according to Aspects 1 to 6 are not limited. However, for example, they may have a sheet shape or a plate shape. In this case, the heat transfer member may also be referred to as a heat transfer sheet or a heat transfer plate. For example, the thickness of the heat transfer member may be within a range of 20 µm to 1 mm or may be within a range of 20 µm to 500 µm. The planar shape of the heat transfer member may be any shape as long as it corresponds to the planar shape of a boundary surface to which heat should be transferred. In order to enhance heat transfer characteristics, there is preferably 1% by volume or less and more preferably 0% by volume of pores in the heat transfer member.

The amount of filler contained in the heat transfer members of Aspects 2, 3, 5, and 6 is not limited. However, it may be within a range of 30% by volume to 90% by volume and is more preferably within a range of 60% by volume to 90% by volume. The heat transfer member according to Aspect 2 may be constituted of only the fluorine-based resin and/or the fluorine-based elastomer and the filler, or may further include 10% by volume or less or more preferably 5% by volume or less of a vulcanizing agent, a plasticizer, and/or the like.

[Aspect 7] A method for manufacturing a heat transfer member according to Aspect 7 of the present invention is a method for manufacturing a heat transfer member including a fluorine-based resin or a fluorine-based elastomer. The method includes a molding step of producing a molded object by heating and molding a material including the fluorine-based resin or the fluorine-based elastomer, and a firing step of firing the molded object and producing a softened fired product having a hardness lower by 7 or greater than a hardness of the molded object measured using a type AM durometer conforming to JIS K 6253-3:2012. The heat transfer member is constituted of the softened fired product.

According to the method for manufacturing a heat transfer member according to Aspect 7, since the molded object obtained in the molding step is fired under the foregoing conditions in the firing step, it is possible to industrially advantageously manufacture a heat transfer member having a high plasma resistance and capable of maintaining a high state of adhesion with respect to various members over a long period of time. It is possible to manufacture the heat transfer members according to Aspects 1 to 6 by the method for manufacturing a heat transfer member according to Aspect 7.

[Aspect 8] A method for manufacturing a heat transfer member according to Aspect 8 further includes, in Aspect 7, a preliminary step of obtaining a plurality of fired bodies by firing the molded object under a plurality of conditions differing in one or both temperature and time, measuring a hardness of the plurality of obtained fired bodies using a type AM durometer conforming to JIS K 6253-3:2012, and comparing the hardness of the molded object and the hardness of the plurality of fired bodies so as to determine a firing temperature and a firing time for obtaining the softened fired product such that the hardness of the fired body is lower by 7 or greater than the hardness of the molded object. In the firing step, the softened fired product is produced by firing the molded object at the firing temperature for the firing time determined in the preliminary step.

In the method for manufacturing a heat transfer member according to Aspect 8, since a molded object is fired in the firing step using the firing temperature and the firing time determined in the preliminary step, a heat transfer member having a hardness lower by 7 or greater than the hardness of the molded object can be stably manufactured with a high probability over a long period of time. It is possible to manufacture the heat transfer members according to Aspects 1 to 6 also by the method for manufacturing a heat transfer member according to Aspect 8.

[Aspect 9] A plasma treatment device according to Aspect 9 of the present invention includes an electrode for a plasma treatment device having vent holes allowing gas for generating plasma to pass therethrough, and a cooling plate. The heat transfer member according to any one of Aspects 1 to 6 is disposed in at least a part between the electrode for a plasma treatment device and the cooling plate.

In the plasma treatment device according to Aspect 9, since the heat transfer member is disposed in at least a part between the electrode for a plasma treatment device and the cooling plate, heat of the electrode for a plasma treatment device heated by plasma can be transferred to the cooling plate with high efficiency. For this reason, thermal uniformity of the electrode for a plasma treatment device is likely to be ensured over a long period of time. The plasma treatment device may also be referred to as a plasma etching device.

[Aspect 10] According to the plasma treatment device of Aspect 10, in Aspect 9, the electrode for a plasma treatment device and the heat transfer member according to any one of Aspects 1 to 6 may be directly bonded to each other.

In the plasma treatment device according to Aspect 10, heat of the electrode for a plasma treatment device can be transferred to the cooling plate with higher efficiency by directly bonding the electrode for a plasma treatment device and the heat transfer member to each other.

[Aspect 11] A plasma treatment device according to Aspect 11 further includes, in Aspect 9 or 10, a focus ring, and a support stand supporting the focus ring. The heat transfer member according to any one of Aspects 1 to 6 is disposed in at least a part between the focus ring and the support stand.

In the plasma treatment device according to Aspect 11, since the heat transfer member is disposed in at least a part between the focus ring and the support stand, heat of the focus ring heated by plasma can be transferred to the support stand with high efficiency. For this reason, plasma treatment with respect to a processing object is likely to be made stable over a long period of time.

[Aspect 12] According to the plasma treatment device of Aspect 12, in any one of Aspects 9 to 11, the focus ring and the heat transfer member are directly bonded to each other. In this case, since the focus ring and the heat transfer member are directly bonded to each other, heat of the focus ring can be transferred to the cooling plate with higher efficiency.

### ADVANTAGEOUS EFFECTS OF INVENTION

As described above, according to each of the aspects of the present invention, it is possible to provide a heat transfer member and a method for manufacturing the same having a high plasma resistance and capable of maintaining a high state of adhesion with respect to various members over a long period of time, and a plasma treatment device in which the temperature of each component inside a chamber is likely to be made stable even if the inside of the chamber is in a vacuum state.

### BRIEF DESCRIPTION OF DRAWINGS

FIG. 1 is a flowchart showing a method for manufacturing a heat transfer member according to an embodiment of the present invention.
FIG. 2 is a longitudinal sectional view showing a plasma treatment device according to the embodiment of the present invention.

### DESCRIPTION OF EMBODIMENTS

Hereinafter, a heat transfer member, a method for manufacturing the same, and a plasma treatment device according to an embodiment of the present invention will be described with reference to the accompanying drawings.

The plasma treatment device according to the present embodiment is, for example, a plasma treatment device such as a plasma etching device or a plasma CVD device used in a semiconductor device manufacturing process. The heat transfer member according to the present embodiment is utilized, for example, as a heat transfer member that is disposed between an electrode for a plasma treatment device having vent holes allowing gas for generating plasma to pass therethrough and a cooling plate and transfers heat of the electrode for a plasma treatment device to the cooling plate, and/or a heat transfer member that is disposed between a focus ring and a support stand supporting the focus ring and transfers heat of the focus ring to the cooling plate. However, the usage of the heat transfer member according to the present invention is not limited to these, and the heat transfer member of the present invention can be disposed and used anywhere between two members that are disposed inside the plasma treatment device and need to transfer heat therebetween.

### <Heat transfer member>

### (First embodiment)

A heat transfer member according to a first embodiment of the present invention is constituted of a fired body of a molded object including a fluorine-based resin or a fluorine-based elastomer. The molded object is molded into a shape that can be used as a heat transfer member. The molded product of the present embodiment is a fired body obtained by firing the foregoing molded object. The method for manufacturing a molded object and the method for firing a molded object will be described below.

A hardness, which is measured using a type AM durometer conforming to JIS K 6253-3 (Vulcanized Rubber and Thermoplastic Rubber - Method for Determining Hardness - Section 3: Durometer Hardness):2012 (which will hereinafter be referred to as "a hardness AM" in this specification) of the heat transfer member (fired body) has a value lower by 7 or greater than the hardness AM of the foregoing molded object. That is, the heat transfer member according to the first embodiment has a lower hardness and higher flexibility than the molded object. For this reason, the heat transfer member according to the first embodiment can be deformed in accordance with a surface shape of various components. The method which will be described below may be used as a hardness measurement method using the type AM durometer.

It is preferable that the hardness AM of the heat transfer member be within a range of 20 to 70. Since it is preferable that the hardness AM of the heat transfer member be small from the viewpoint of adhesion to other components, it is preferably 50 or lower and is more preferably 30 or lower.

The heat transfer member may include a fluorine-based resin or a fluorine-based elastomer alone or may include a fluorine-based resin and a fluorine-based elastomer as a mixture. The amounts of the fluorine-based resin and the fluorine-based elastomer contained in the heat transfer member are not limited. However, they may be 10% by volume to 100% by volume, is preferably 20% by volume to 80% by volume, or is more preferably 40% by volume to 60% by volume. If the amount of the fluorine-based resin or the fluorine-based elastomer contained therein is 20% by volume or larger, the plasma resistance is likely to be sufficiently increased, and it is easier to maintain a high state of adhesion with respect to various members over a long period of time.

It is preferable that the heat transfer member include a filler. It is preferable that the heat transfer member have a constitution in which at least one of a fluorine-based resin and a fluorine-based elastomer (organic components) is used as a matrix binder and a filler component is dispersed in this matrix binder.

It is preferable that the fluorine-based resin have a fluorine-containing group in a main chain. The fluorine-based resin may be a gel-like resin having a three-dimensional crosslinked structure. It is preferable that the fluorine-based elastomer be a fluorine-containing three-dimensional crosslinked compound having a fluorine-containing group and a three-dimensional crosslinked structure. The fluorine-containing group can include a perfluoroalkylene group-(CF₂)ₓ-(x is an integer of 1 or larger) and a perfluoropolyether group. Examples of the perfluoropolyether group can include -(CF₂CF₂O)ₘ(CF₂O)ₙ-(m and n are integers of 1 or larger), -(CF₂CF₂CF₂O)ₚ-(p is an integer of 1 or larger), -(CF₂CF(CF₃)O)_{q}-(q is an integer of 1 or larger).

The three-dimensional crosslinked structure can include an organosilicon structure having silicon-carbon bonds, a silicone structure having siloxane bonds, an epoxy structure having epoxy bonds, a urethane structure having urethane bonds, and the like. Regarding the fluorine-containing three-dimensional crosslinked compound, one kind may be used alone, or two or more kinds may be used in a combination. It is preferable that the fluorine-based elastomer be a compound having a silicone structure constituted of a perfluoropolyether skeleton and having siloxane bonds.

Alumina (Al₂O₃), alumina hydrate, aluminum nitride (AlN), boron nitride (BN), silicon (Si), silica (SiO₂), silicon carbide (SiC), titanium dioxide (TiO₂), or the like can be used as a material of the filler. Among these materials, alumina, aluminum nitride, boron nitride, and silicon are particularly preferable. Regarding the filler, one kind may be used alone, or two or more kinds may be used in a combination. In addition, two or more kinds of fillers may be two or more kinds of fillers made of different materials or may be two or more kinds of fillers made of the same material having different physical properties such as an average particle size (d50). The heat transfer member can be filled with fillers at a higher density using two or more kinds of fillers having different average particle sizes. When two or more kinds of fillers having different average particle sizes are used, it is preferable that the average particle size of the filler having a relatively large average particle size (large particle-sized filler) be within a range of 1.5 times to 10 times the average particle size of the filler having a relatively small average particle size (small particle-sized filler). More preferably, regarding the average particle size, the average particle size of the large particle-sized filler may be within a range of 2 times to 8 times the average particle size of the small particle-sized filler.

The amount of the filler component contained in the heat transfer member is preferably within a range of 30% by volume to 90% by volume and is more preferably within a range of 60% by volume to 90% by volume. If the amount of contained filler component is 30% by volume or larger, the heat conductivity of the heat transfer member is improved, and if the amount of contained filler component is 90% by volume or smaller, shape stability of the heat transfer member is improved. The heat transfer member may be constituted of only the fluorine-based resin and/or the fluorine-based elastomer and the filler, or may further include a vulcanizing agent, a plasticizer, and/or the like in addition to these.

The shape of the heat transfer member varies depending on the component used. However, it may be a sheet shape or a plate shape. In this case, the heat transfer member may also be referred to as a heat transfer sheet or a heat transfer plate. The thickness of the heat transfer member is not limited. However, for example, it may be within a range of 20 µm to 1 mm or may be within a range of 20 µm to 500 µm. The planar shape of the heat transfer member may be any shape as long as it corresponds to the planar shape of a boundary surface to which heat should be transferred. In order to facilitate use of the heat transfer member, plastic release sheets may be attached to both surfaces of the heat transfer member and peeled off when the heat transfer member is used. In addition, the release sheets may have a pressure sensitive adhesive layer having a weak adhesive force on a surface on the heat transfer member side. The heat transfer member may be provided in a roll shape or may be provided by being wound around some kind of core material.

Since the heat transfer member of the present embodiment having the constitution as above includes a fluorine-based resin or a fluorine-based elastomer, it has a high plasma resistance. In addition, the heat transfer member of the present embodiment is a fired body, of which the hardness AM has a value lower by 7 or greater than the hardness AM of the molded object before firing, and therefore it has a low hardness and high flexibility. For this reason, according to the heat transfer member of the present embodiment, adhesion of the heat transfer member with respect to various components is improved.

In the heat transfer member of the present embodiment, when the molded object includes a filler, the heat conductivity of the heat transfer member is further improved. When the filler is at least one kind of inorganic materials selected from the group consisting of alumina, aluminum nitride, boron nitride, and silicon, the heat conductivity of the heat transfer member is further improved.

### (Second embodiment)

The heat transfer member according to a second embodiment of the present invention is constituted of a molded product including a fluorine-based resin or a fluorine-based elastomer. The molded product may be a fired body of a molded object including a fluorine-based resin or a fluorine-based elastomer. In this case, similar to the heat transfer member of the first embodiment, the hardness AM of the fired body may be lower by 7 or greater than the hardness AM of the molded object.

In the heat transfer member of the second embodiment, the amount of change in the hardness AM after heating at 250°C for 25 hours, that is, a value obtained by subtracting the hardness AM before heating from the hardness AM after heating at 250°C for 25 hours is within a range of ±5, and therefore it has high thermal stability and is sufficiently softened. Since it has high thermal stability and is sufficiently softened, it can maintain a high state of adhesion with respect to various members over a long period of time even under a high-temperature environment such as inside a chamber of the plasma treatment device. It is preferable that the amount of change in the hardness AM after heating at 250°C for 25 hours be within a range of ±3. The atmosphere during heat treatment is set to an atmosphere of air at a normal pressure or an inert gas such as nitrogen, and the temperature of the heat transfer member during hardness measurement is set to a normal temperature.

It is preferable that the hardness AM of the heat transfer member be within a range of 25 to 70. In addition, the heat transfer member may include a fluorine-based resin or a fluorine-based elastomer alone or may include a fluorine-based resin and a fluorine-based elastomer as a mixture. It is preferable that the heat transfer member include a filler. It is preferable that the heat transfer member have a constitution in which at least one of a fluorine-based resin and a fluorine-based elastomer (organic components) is used as a matrix binder and a filler component is dispersed in this matrix binder. The materials of the fluorine-based resin, the fluorine-based elastomer, and the filler, the amount of the filler component contained in the heat transfer member, and the shape of the heat transfer member are the same as those of the case of the first embodiment.

Since the heat transfer member of the present embodiment having the constitution as above includes a fluorine-based resin or a fluorine-based elastomer, it has a high plasma resistance. In addition, in the heat transfer member of the present embodiment, the amount of change in the hardness AM after heating at 250°C for 25 hours is within a range of ±5, and therefore it has high thermal stability and high flexibility. For this reason, according to the heat transfer member of the present embodiment, adhesion of the heat transfer member with respect to various components is improved. Moreover, since the heat transfer member of the present embodiment has high thermal stability, it can maintain a high state of adhesion with respect to various members over a long period of time even under a high-temperature environment such as inside the chamber of the plasma treatment device.

In the heat transfer member of the present embodiment, when the molded object includes a filler, the heat conductivity of the heat transfer member is further improved. When the filler is at least one kind of inorganic materials selected from the group consisting of alumina, aluminum nitride, boron nitride, and silicon, the heat conductivity of the heat transfer member is further improved.

### <Method for manufacturing heat transfer member>

Next, a method for manufacturing the heat transfer member of the present embodiment will be described.

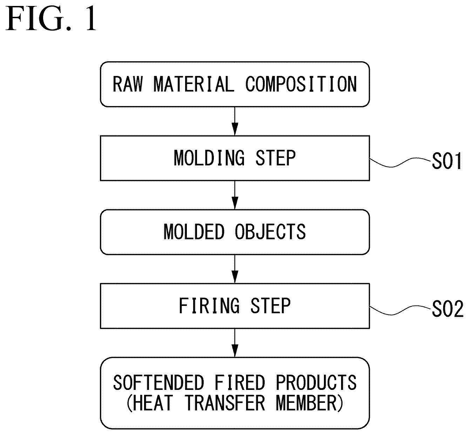

FIG. 1 is a flowchart showing the method for manufacturing the heat transfer member according to the present embodiment. As shown in FIG. 1, the method for manufacturing the heat transfer member of the present embodiment has a molding step S01 and a firing step S02.

The molding step S01 is a step of producing a molded object by heating and molding a raw material composition. The raw material composition is constituted of a material including a fluorine-based resin or a fluorine-based elastomer and includes a filler as necessary. It is preferable that the material including a fluorine-based resin or a fluorine-based elastomer have thermal crosslinking properties of crosslinking that occurs due to heat. Commercially available products can be used as a fluorine-based resin and a fluorine-based elastomer having thermal crosslinking properties. For example, SHIN-ETSU SIFEL (registered trademark) series or the like manufactured by Shin-Etsu Chemical Co., Ltd. can be used as the fluorine-based resin and the fluorine-based elastomer that are commercially available.

For example, the raw material composition can be heated and molded by putting the raw material composition into a mold and heating it while pressurizing it using a heat-pressing machine. Heating using this heat-pressing machine may be regarded as primary vulcanization, and secondary vulcanization may be performed. For example, the secondary vulcanization may be performed by taking out a primary vulcanizate obtained through the primary vulcanization from a mold and heating it at a temperature higher than the heating temperature during the primary vulcanization. The heating temperature in the primary vulcanization varies depending on the kind or the amount of the fluorine-based resin and the fluorine-based elastomer included in the raw material composition. However, for example, it is within a range of 120°C to 200°C. The pressurization pressure in the primary vulcanization is 15 MPa, for example. The heating temperature in the secondary vulcanization is a temperature higher than the heating temperature in the primary vulcanization and is a temperature equal to or lower than the thermal decomposition temperature of the primary vulcanizate. For example, the heating temperature in the secondary vulcanization can be a temperature higher than the heating temperature in the primary vulcanization within a range of 10°C to 50°C.

The firing step S02 is a step of firing the molded object obtained in the molding step S01 and producing a softened fired product having the hardness AM lower by 7 or greater than the hardness AM of the molded object. The heating temperature in the firing step S02 is a temperature higher than the heating temperature in the secondary vulcanization and is a temperature equal to or lower than the thermal decomposition temperature of the molded object. The heating temperature in the firing step S02 can be a temperature higher than the heating temperature in the secondary vulcanization within a range of 10°C to 150°C. The heating temperature in the firing step S02 is, for example, 200°C or higher, is preferably 250°C or higher, and is more preferably 300°C or higher.

A preliminary step may be performed in order to decide a firing temperature and a firing time in the firing step S02.

In the preliminary step, a plurality of fired bodies are obtained by firing the molded object obtained in the molding step S01 under a plurality of conditions differing in one or both temperature and time. Next, the hardness AM of the plurality of obtained fired bodies is measured. Further, the hardness AM of the molded object and the hardness AM of the plurality of fired bodies are compared so as to determine a firing temperature and a firing time for obtaining a softened fired product such that the hardness AM of the fired body is lower by 7 or greater than the hardness AM of the molded object.

In the firing step S02, a softened fired product is produced by firing the molded object at the firing temperature for the firing time determined in the preliminary step. A softened fired product having a predetermined hardness AM can be obtained with a high probability by firing the molded object at the firing temperature for the firing time obtained in the preliminary step.

In the preliminary step, it is more preferable to determine a firing temperature and a firing time for obtaining a softened fired product in which the amount of change from before heating after heating at 250°C for 25 hours becomes ±5. A softened fired product having a predetermined hardness AM and further having high thermal stability of the hardness AM can be obtained by firing the molded object at this firing temperature for this firing time.

According to the method for manufacturing the heat transfer member of the present embodiment having the constitution as above, since the molded object obtained in the molding step S01 is fired under the foregoing conditions in the firing step S02, it is possible to industrially advantageously manufacture a heat transfer member having the hardness AM lower by 7 or greater than the hardness AM of the molded object.

In the method for manufacturing the heat transfer member of the present embodiment, a heat transfer member having the hardness AM lower by 7 or greater than the hardness AM of the molded object can be stably manufactured with a higher probability over a long period of time by firing the molded object in the firing step S02 using the firing temperature and the firing time determined in the foregoing preliminary step.

In the method for manufacturing the heat transfer member of the present embodiment, a raw material composition is put into a mold to be heated and molded in the molding step S01. However, a method for producing a molded object is not limited to this. For example, a molded object may be produced by coating one of a pair of components, which will have the heat transfer member interposed therebetween, with a raw material composition and heating the obtained coating film. The coating film may be heated while the coating film is pressurized. In addition, the secondary vulcanization may be performed by disposing the primary vulcanizate in one of the pair of components, which will have the heat transfer member interposed therebetween, while pressing the primary vulcanizate against the component. Moreover, the firing step S02 may be performed by disposing the molded object in one of the pair of components, which will have the heat transfer member interposed therebetween, while pressing the molded obj ect.

### <Plasma treatment device>

Next, a plasma treatment device using the heat transfer member of the present embodiment will be described.

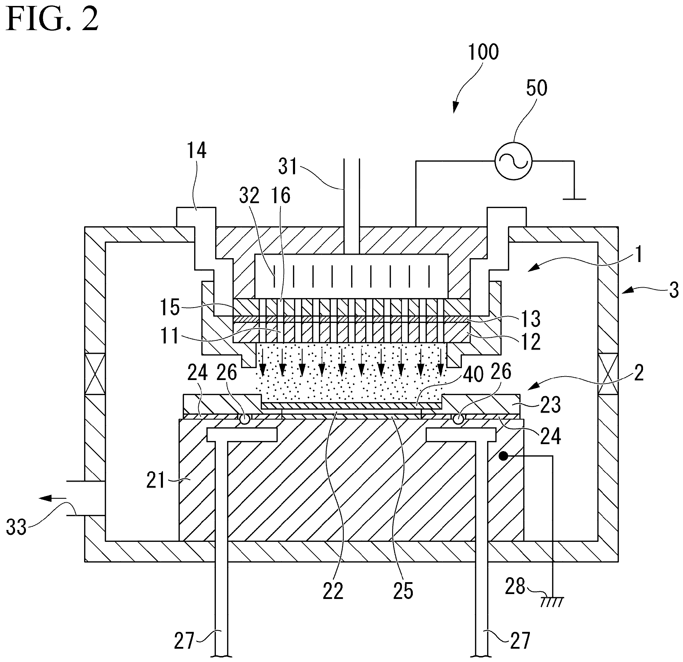

FIG. 2 is a longitudinal sectional view showing an example of a plasma etching device according to the embodiment of the present invention.

A plasma etching device 100 shown in FIG. 2 has a chamber 3 internally having an airtight space, an etching gas introduction portion 1 provided on an upward side inside the chamber 3, and a processing object support portion 2 provided on a downward side inside the chamber 3.

The etching gas introduction portion 1 includes an electrode 12 for the plasma treatment device, and a cooling plate 15 for cooling the electrode 12 for the plasma treatment device. A heat transfer member 13 that has been described above and has a sheet shape is disposed in at least a part between the electrode 12 for the plasma treatment device and the cooling plate 15. The heat transfer member 13 is preferably disposed in a region occupying 80% or more than the area of a facing part in which the electrode 12 for the plasma treatment device and the cooling plate 15 face each other and is more preferably disposed in the facing part in its entirety.

In addition, it is preferable that the electrode 12 for the plasma treatment device and the heat transfer member 13 be directly bonded to each other and both be integrated in advance for the reason that assembling and positioning are facilitated or the like. For example, a method for heating the electrode 12 for the plasma treatment device and the heat transfer member 13 in a contact state can be used as a method for directly bonding the electrode 12 for the plasma treatment device and the heat transfer member 13 to each other. The electrode 12 for the plasma treatment device and the heat transfer member 13 may be heated while being pressurized.

The electrode 12 for the plasma treatment device has many vent holes 11 allowing gas for generating plasma to pass therethrough. Meanwhile, in the cooling plate 15, penetration holes 16 are formed at the same pitch as the vent holes 11 in a manner of respectively matching the vent holes 11 of the electrode 12 for the plasma treatment device. The cooling plate 15 is supported by an insulator 14 in an insulated state in the chamber 3. The electrode 12 for the plasma treatment device is connected to a high-frequency power source 50 and functions as an electrode portion.

The processing object support portion 2 includes a support stand 21, an electrostatic chuck 22 disposed at the center of the support stand 21, and a focus ring 23 disposed around the electrostatic chuck 22. A heat transfer member 24 that has been described above and has a sheet shape is disposed in at least a part between the support stand 21, the focus ring 23, and the support stand 21. The heat transfer member 24 is preferably disposed in a region occupying 80% or more than the area of a facing part in which the support stand 21 and the focus ring 23 face each other and is more preferably disposed in the facing part in its entirety.

It is preferable that the focus ring 23 and the heat transfer member 24 be directly bonded to each other and both be integrated in advance for the reason that assembling and positioning are facilitated or the like. For example, a method for heating the focus ring 23 and the heat transfer member 24 in a contact state can be used as a method for directly bonding the focus ring 23 and the heat transfer member 24 to each other. The focus ring 23 and the heat transfer member 24 may be heated while being pressurized.

A heat sink 25 is disposed between the support stand 21 and the electrostatic chuck 22. A wafer (a substrate to be processed) 40 is placed on the electrostatic chuck 22 in a state in which a circumferential edge portion is supported by the focus ring 23. In addition, an O-ring 26 is disposed between the support stand 21 and the focus ring 23. The support stand 21 internally has a refrigerant flow channel 27 and also functions as a cooling portion. In addition, the support stand 21 is connected to an earth 28 and also functions as an electrode portion.

An etching gas supply pipe 31 is disposed on the upward side of the chamber 3. An exhaust port 33 is disposed in a side portion of the chamber 3. Etching gas sent from the etching gas supply pipe 31 goes through a diffusion member 32 and is then supplied toward the wafer 40 through the vent holes 11 of the electrode 12 for the plasma treatment device. Due to a radio frequency (RF) voltage applied between the electrode 12 for the plasma treatment device and the support stand 21, the etching gas supplied toward the wafer 40 is in a plasma state so that the wafer 40 is subjected to etching processing.

According to the plasma etching device 100 of the present embodiment as above, since the heat transfer member 13 is disposed in at least a part between the electrode 12 for the plasma treatment device and the cooling plate 15, heat of the electrode 12 for the plasma treatment device heated by plasma can be transferred to the cooling plate 15 with high efficiency. For this reason, thermal uniformity of the electrode 12 for the plasma treatment device is likely to be ensured over a long period of time. In addition, heat of the electrode 12 for the plasma treatment device can be transferred to the cooling plate 15 with higher efficiency by directly bonding the electrode 12 for the plasma treatment device and the heat transfer member 13 to each other.

In addition, according to the plasma etching device 100 of the present embodiment, since the heat transfer member 24 is disposed in at least a part between the focus ring 23 and the support stand 21, heat of the focus ring 23 heated by plasma can be transferred to the support stand 21 with high efficiency. For this reason, plasma treatment with respect to a processing object is likely to be made stable over a long period of time. In addition, heat of the focus ring 23 can be transferred to the heat sink 25 with higher efficiency by directly bonding the focus ring 23 and the heat transfer member 24 to each other.

Hereinabove, the embodiments of the present invention have been described. However, the present invention is not limited to these and can be suitably changed within a range not departing from the technical idea of the invention.

### EXAMPLES

### [Example 1 of present invention]

### (1) Production of raw material composition

A liquid fluorine-based elastomer (X-71-358-4, manufactured by Shin-Etsu Chemical Co., Ltd.) having a perfluoropolyether group and having thermal crosslinking properties was prepared as an organic component. In addition, a large particle-sized alumina filler (AA-18, manufactured by SUMITOMO CHEMICAL COMPANY, LIMITED, average particle size (d50): 18 µm) was prepared as a first filler, and a small particle-sized alumina filler (AA-3, manufactured by SUMITOMO CHEMICAL COMPANY, LIMITED, average particle size (d50): 3 µm) was prepared as a second filler.

The organic component in a ratio of 10 parts by mass (40 parts by volume as the amount of organic component), the first filler in a ratio of 19.5 parts by mass (36 parts by volume), and the second filler in a ratio of 13 parts by mass (24 parts by volume) were mixed. A raw material composition was produced by kneading the obtained mixture while performing defoaming using a rotation/revolution vacuum mixer (THINKY MIXER ARV-310, manufactured by THINKY CORPORATION).

### (2) Production of molded object

The raw material composition obtained in the foregoing (1) was put into a mold and subjected to primary vulcanization using a heat-pressing machine under conditions of 150°C for ten minutes, and a sheet-shaped primary vulcanizate was obtained. The thickness of the primary vulcanizate was set to 200 µm. Next, the obtained primary vulcanizate was taken out from the mold, and secondary vulcanization was performed under conditions of 200°C for four hours. In this manner, a molded object was obtained.

### (3) Production of fired body

The molded object obtained in the foregoing (2) was fired under conditions of 300°C for five hours, and a fired body was obtained.

### [Examples 2 to 3 and 5 to 7 of present invention, and Comparative Examples 1 and 2]

Raw material compositions were produced in a manner similar to that of Example 1 of the present invention, except that the kinds of materials shown in the following Table 1 were used as the organic components in production of a raw material composition in the foregoing (1), and the amount of the first filler contained in a filler component and the amount of the filler component contained in the raw material composition were set to the amounts shown in the following Table 1. The same fluorine-based elastomers as that of Example 1 of the present invention were used for Examples 2 to 3 and 5 of the present invention. X-71-359 manufactured by Shin-Etsu Chemical Co., Ltd. was used as the fluorine-based elastomer of Example 6 of the present invention. A fluorine-based resin having equal parts by mass of X-71-6053-6A and X-71-6053-6B manufactured by Shin-Etsu Chemical Co., Ltd. blended therein was used for Example 7 of the present invention. A silicone rubber having equal parts by mass of KE-1950-10A and KE-1950-10B manufactured by Shin-Etsu Chemical Co., Ltd. blended therein was used for Comparative Example 2.

A molded object was produced in a manner similar to that of Example 1 of the present invention, except that the temperatures and the times of the primary vulcanization and the secondary vulcanization were set to the temperatures and the times shown in the following Table 1 in production of a molded object in the foregoing (2). The secondary vulcanization was not performed for Example 6 of the present invention.

A fired body was produced in a manner similar to that of Example 1 of the present invention, except that the heating temperature and the heating time were set to the temperature and the time shown in the following Table 1 in production of a fired body in the foregoing (3). The thickness of the obtained fired body was approximately 200 µm.

### [Example 4 of present invention]

A raw material composition was produced in a manner similar to that of Example 1 of the present invention, except that the ratio of the first filler was set to 42 parts by volume and the ratio of the second filler was set to 18 parts by volume in production of a raw material composition in the foregoing (1). A molded object was obtained in a manner similar to that of Example 1 of the present invention, except that the obtained raw material composition was used in production of a molded object in the foregoing (2). The obtained molded object and a silicon wafer were overlapped and were fired under conditions of 350°C for one hour to generate a fired body of the molded object, thereby producing a silicon wafer with a fired body.

### [Example 8 of present invention]

A coating film having a thickness of 50 µm was formed by coating a surface of the silicon wafer with a liquid fluorine-based elastomer (X-71-358-4, manufactured by Shin-Etsu Chemical Co., Ltd.). Next, the coating film was made into a molded object by performing the primary vulcanization with respect to the silicon wafer with a coating film under conditions of 150°C for ten minutes and then performing the secondary vulcanization under conditions of 200°C for four hours. Next, a silicon wafer with a fired body was produced by firing the silicon wafer with a molded object under conditions of 300°C for five hours to generate a fired body of the molded object.

**TABLE 1**

| | Production of raw material composition | | | | | Production of molded object | | | | Production of fired product | |
|---|---|---|---|---|---|---|---|---|---|---|---|
| | Organic component | Filler component | | | Amount of filler component contained in raw material composition *) [% by volume] | Primary vulcanization | | Secondary vulcanization | | Heating temp. [°C] | Heating time [hr] |
| | Kind | First filler | Second filler | Amount of first filler contained in filler component [% by volume] | | | | | | | |
| | | | | | | Temp. [°C] | Time [min] | Temp. [°C] | Time [min] | | |
| Example 1 of present invention | Fluorine-based elastomer | Large particle-sized alumina | Small particle-sized alumina | 60 | 60 | 150 | 10 | 200 | 4 | 300 | 5 |
| Example 2 of present invention | Fluorine-based elastomer | Large particle-sized alumina | Small particle-sized alumina | 50 | 40 | 150 | 10 | 200 | 4 | 250 | 25 |
| Example 3 of present invention | Fluorine-based elastomer | Large particle-sized alumina | Small particle-sized alumina | 50 | 60 | 150 | 10 | 200 | 4 | 250 | 25 |
| Example 4 of present invention | Fluorine-based elastomer | Large particle-sized alumina | Small particle-sized alumina | 70 | 60 | 150 | 10 | 200 | 4 | 350 | 1 |
| Example 5 of present invention | Fluorine-based elastomer | Large particle-sized alumina | Small particle-sized alumina | 40 | 30 | 150 | 10 | 200 | 4 | 250 | 25 |
| Example 6 of present invention | Fluorine-based elastomer | Large particle-sized alumina | Small particle-sized alumina | 50 | 60 | 150 | 10 | - | - | 300 | 25 |
| Example 7 of present invention | Fluorine-based resin | Large particle-sized alumina | Small particle-sized alumina | 80 | 90 | 150 | 10 | 200 | 4 | 300 | 25 |
| Example 8 of present invention | Fluorine-based elastomer | - | - | - | - | 150 | 10 | 200 | 4 | 300 | 5 |
| Comparative Example 1 | Fluorine-based elastomer | Large particle-sized alumina | Small particle-sized alumina | 60 | 50 | 150 | 10 | 200 | 4 | 200 | 5 |
| Comparative Example 2 | Silicone rubber | Large particle--sized alumina | Small particle-sized alumina | 50 | 30 | 120 | 10 | 150 | 1 | 250 | 25 |

| | | | | | | | | | | | |
|---|---|---|---|---|---|---|---|---|---|---|---|
| *) The amount of the filler component contained in the solid content excluding the solvent | | | | | | | | | | | |

### [Evaluation]

The hardness AM and the heat resistance value of the obtained molded objects and fired bodies were measured by the following method. In addition, for the fired bodies, the hardness AM after heating at 250°C for 25 hours was measured as described below. Table 2 shows the results.

### (Method for measuring hardness AM)

Measurement was performed using a rubber hardness tester equipped with a push pin of a type AM durometer by a method conforming to JIS K 6253-3:2012. A durometer hardness was a value obtained from the depth of penetration when the stipulated push pin was vertically pushed into a test piece under stipulated conditions. A pressurization plate of the type AM durometer had a diameter of 9.0±0.3 mm, and a center hole having a diameter of 1.19±0.03 mm was formed at the center. While the sample was pressed horizontally by the pressurization plate, the depth of penetration was measured by pressing the push pin against the sample surface through the center hole of the pressurization plate. In the type AM, there was a need to have a sample thickness of 1.5 mm or larger. When this thickness was not satisfied, measurement was performed by laminating the heat transfer members until the thickness exceeded 1.5 mm. In the type AM, measurement was performed 5 times in total at measurement positions apart from each other by 0.8 mm or more, and a median thereof was taken.

### (Method for measuring heat resistance value)

The heat resistance value was measured by a steady-state method conforming to JIS H7903:2008 and ASTM D5470-1. An upper alumina block having an upper portion in contact with a heating portion and a lower alumina block having a lower portion in contact with a cooling portion are installed inside a chamber, and five thermocouples were attached to each of the upper and lower alumina blocks at intervals of 6 mm. In addition, a laminate in which the silicon wafer, the sample (a molded object and a fired body), and a single-sided anodized aluminum plate were laminated in this order from above was produced. The surface where upper alumina block and the lower alumina block faced each other was coated with a heat transfer grease, and the foregoing laminate was installed therebetween. A weight was installed in the upper portion of the upper alumina block such that a load of 16 kPa was applied to the sample, and the heat resistance value was measured by setting the pressure inside the chamber to 5Pa.

### (Method for measuring hardness AM after heating at 250°C for 25 hours)

The fired body (sample) was put into an electric furnace and was heated in the atmosphere at 250°C for 25 hours. After cooling to room temperature, the hardness AM was measured.

**TABLE 2**

| | Hardness AM | | | Heat resistance value [cm²K/W] | | | Hardness AM after heating at 250°C for 25 hrs. | | |
|---|---|---|---|---|---|---|---|---|---|
| | Molded object | Fired product | Amount of change in hardness AM | Molded object | Fired product | Amount of change in heat resistance value | Before heating | After heating | Amount of change in hardness AM |
| Example 1 of present invention | 65 | 42 | -23 | 11.1 | 7.8 | -3.3 | 42 | 44 | 2 |
| Example 2 of present invention | 42 | 32 | -10 | 14.3 | 10.5 | -3.8 | 32 | 30 | -2 |
| Example 3 of present invention | 67 | 60 | -7 | 11.2 | 8.3 | -2.9 | 60 | 57 | -3 |
| Example 4 of present invention | 63 | 38 | -25 | 108 | 6.8 | -4.0 | 38 | 41 | 3 |
| Example 5 of present invention | 33 | 25 | -8 | 14.9 | 10.6 | -4.3 | 25 | 24 | -1 |
| Example 6 of present invention | 67 | 47 | -20 | 11.3 | 7.9 | -3.4 | 47 | 50 | 3 |
| Example 7 of present invention | 88 | 68 | -20 | 9.6 | 7.2 | -2.4 | 68 | 70 | 2 |
| Example 8 of present invention | 28 | 21 | -7 | 16.5 | 14.9 | -1.6 | 21 | 22 | 1 |
| Comparative Example 1 | 61 | 59 | -2 | 13.8 | 14.0 | 0.2 | 59 | 41 | -18 |
| Comparative Example 2 | 32 | 50 | 18 | 14.6 | 15.1 | 0.5 | 50 | 74 | 24 |

From the results of Table 2, it was understood that the laminates using the fired bodies of Examples 1 to 8 of present invention having the hardness AM lower by 7 or greater than the molded product had a significantly decreased heat resistance value. The reason for this was considered to be that adhesion between the silicon wafer and the single-sided anodized aluminum plate was improved due to decrease in the hardness AM of the fired body. From this result, it was confirmed that the fired bodies of Examples 1 to 8 of present invention were effective as the heat transfer members. Particularly, the heat resistance values of the fired bodies obtained in Examples 1, 3, 4, 6, and 7 of the present invention in which the amount of the filler component contained in the raw material composition was 60% by volume or larger were 10 cm²K/W or smaller. Moreover, the heat resistance values of the fired bodies obtained in Examples 1, 4, 6, and 7 of the present invention in which the heating temperature during production of the fired body was 300°C or higher were 8 cm²K/W or smaller. Meanwhile, the laminate using the fired body of Comparative Example 1 in which the amount of decrease in the hardness AM with respect to the molded product was small had almost the same heat resistance value as the laminate using the molded product. Moreover, in Comparative Example 2 using silicone rubber, the hardness AM increased through firing.

### (Evaluation of plasma resistance)

In Comparative Example 2 in which the heat transfer member was molded using silicone rubber, the areas exposed to plasma were slightly hardened. However, in Examples 1 to 8 of present invention and Comparative Example 1 in which the heat transfer members were molded using a fluorine-based resin or a fluorine-based elastomer, even the areas exposed to plasma were not hardened

### INDUSTRIAL APPLICABILITY

According to the present invention, it is possible to provide a heat transfer member and a method for manufacturing the same having a high plasma resistance and capable of maintaining a high state of adhesion with respect to various members over a long period of time, and a plasma treatment device in which the temperature of each component inside a chamber is likely to be made stable even if the inside of the chamber is in a vacuum state.

### REFERENCE SIGNS LIST

1 Etching gas introduction portion
2 Processing object support portion
3 Chamber
11 Vent hole
12 Electrode for plasma treatment device
13 Heat transfer member
14 Insulator
15 Cooling plate
16 Penetration hole
21 Support stand
22 Electrostatic chuck
23 Focus ring
24 Heat transfer member
25 Heat sink
26 O-ring
27 Refrigerant flow channel
28 Earth
31 Etching gas supply pipe
32 Diffusion member
33 Exhaust port
40 Wafer
50 High-frequency power source
100 Plasma etching device

## Claims

1. A heat transfer member constituted of a fired body of a molded object including a fluorine-based resin or a fluorine-based elastomer,
wherein a hardness measured using a type AM durometer conforming to JIS K 6253-3:2012 is lower by 7 or greater than a hardness of the molded object.

2. The heat transfer member according to claim 1,
wherein the molded object includes a filler.

3. The heat transfer member according to claim 2,
wherein the filler is at least one kind of inorganic materials selected from the group consisting of alumina, aluminum nitride, boron nitride, and silicon.

4. A heat transfer member constituted of a molded product including a fluorine-based resin or a fluorine-based elastomer,
wherein an amount of change in hardness measured using a type AM durometer conforming to JIS K 6253-3:2012 from before heating after heating at 250°C for 25 hours is within a range of ±5.

5. The heat transfer member according to claim 4,
wherein the molded product includes a filler.

6. The heat transfer member according to claim 5,
wherein the filler is at least one kind of inorganic materials selected from the group consisting of alumina, aluminum nitride, boron nitride, and silicon.

7. A method for manufacturing a heat transfer member including a fluorine-based resin or a fluorine-based elastomer, the method comprising:
a molding step of producing a molded object by heating and molding a material including the fluorine-based resin or the fluorine-based elastomer; and
a firing step of firing the molded object and producing a softened fired product having a hardness lower by 7 or greater than a hardness of the molded object measured using a type AM durometer conforming to JIS K 6253-3:2012,
wherein the heat transfer member is constituted of the softened fired product.

8. A method for manufacturing the heat transfer member according to claim 7, further comprising:
a preliminary step of obtaining a plurality of fired bodies by firing the molded object under a plurality of conditions differing in one or both temperature and time, measuring a hardness of the plurality of obtained fired bodies using a type AM durometer conforming to JIS K 6253-3:2012, and comparing the hardness of the molded object and the hardness of the plurality of fired bodies so as to determine a firing temperature and a firing time for obtaining the softened fired product such that the hardness of the fired body is lower by 7 or greater than the hardness of the molded object,
wherein in the firing step, the softened fired product is produced by firing the molded object at the firing temperature for the firing time determined in the preliminary step.

9. A plasma treatment device comprising:
an electrode for a plasma treatment device having vent holes allowing gas for generating plasma to pass therethrough; and
a cooling plate,
wherein the heat transfer member according to any one of claims 1 to 6 is disposed in at least a part between the electrode for a plasma treatment device and the cooling plate.

10. The plasma treatment device according to claim 9,
wherein the electrode for a plasma treatment device and the heat transfer member are directly bonded to each other.

11. A plasma treatment device comprising:
a focus ring; and
a support stand supporting the focus ring,
wherein the heat transfer member according to any one of claims 1 to 6 is disposed in at least a part between the focus ring and the support stand.

12. The plasma treatment device according to claim 11,
wherein the focus ring and the heat transfer member are directly bonded to each other.
